# EUROPEAN PATENT APPLICATION

(11) **EP 3 447 734 A1**
(43) Date of publication of application: **27.02.2019**
(21) Application number: 17187718.6
(22) Date of filing: 24.08.2017
(51) Int. Cl.: G06T 11/60

(54) **METHOD FOR CREATING A PSEUDO CT IMAGE**

(71) Applicant: Koninklijke Philips N.V., 5656 AE Eindhoven (NL)
(72) Inventor: VAHALA, Erkki Tapani, 5656 AE Eindhoven (NL)
(74) Representative: de Haan, Poul Erik

(57) **Abstract**

A method for creating a pseudo CT image from a region of interest. The method comprises the following steps. Receiving one or more magnetic resonance images comprising the region of interest. Creating a pseudo CT image by determining a pseudo Hounsfield Unit value for one or more voxels in the region of interest based on the one or more magnetic resonance images.

Setting a voxel value to one or more voxels in the pseudo CT image in order to indicate that the image is a pseudo CT image.

Hereby the likelihood of errors in an MRI based radiotherapy workflow may be reduced.

## Description

### FIELD OF THE INVENTION

The invention relates to the field of radiotherapy and more specifically to an magnetic resonance based workflow for radiotherapy

### BACKGROUND OF THE INVENTION

In external beam radiation therapy planning, a treatment is simulated in the actual treatment position on a computed tomography (CT) or magnetic resonance imaging (MRI) scanner. Depending on the imaging modality used, CT or MRI images are acquired while the patient is in the treatment position. These acquired images are used in order to create a treatment plan. Treatment plan creation is typically done by means of a treatment planning system (TPS). In order to create a treatment plan, information is needed about the position of a treatment target (e.g. a tumor). Also the position of organs at risk need to be known. A treatment goal could be to apply a high radiation dose to the treatment target, while limiting the dose to the organs at risk. In addition to the positions of the treatment target and the organs at risk, in order to create a treatment plan, the treatment planning system needs to be provided with information on how radiation is attenuated in the body of a patient to be treated. This information can be derived directly from CT images. In general, CT images display Hounsfield units (HU). HU are a measure for radiation attenuation. However, this information is not directly available from MRI images. However, methods exists that allow the derivation of a pseudo CT image from one or more MRI images. A pseudo CT image comprises pseudo Hounsfield Units, which are a measure for radiation attenuation. A workflow for creating a treatment plan based on MRI images, is herein called an "MRI based radiotherapy workflow".

WO 2015/150065 A1 describes a method of creating a pseudo CT image. The method comprising the steps of: determination of a relative prevalence of a first tissue class and second tissue class within the volume element from a first magnetic resonance image and second magnetic resonance image respectively. Then a a relative prevalence of a third tissue class is determined within the volume element based on subtraction of a relative prevalence of the first and/or second tissue class from a total tissue prevalence. A reference Hounsfield Unit value is provided for the first, second and third tissue class. Finally, a pseudo Housfield value is estimated for the volume element by determining a weighted sum of the first, second and third reference Hounsfield unit value, with weight factors which are based on the determined relative prevalences of the first, second and third tissue class.

### SUMMARY OF THE INVENTION

It is an object of the invention to reduce the likelihood of errors in an MRI based radiotherapy workflow. This object is achieved by a method according to claim 1.

When a pseudo CT image is created, the resulting image may look like a real CT image. This is especially the case with continuous grey value scale pseudo CT images.

It is an insight of the inventor that a user may confuse the pseudo CT image for a real CT. This in turn may lead to incorrect dose if the image is used for drawing contours or judging the plan accuracy without taking into account the MRI-origin of the image.

It is a further insight of the inventor that attaching of overlays or textual information to DICOM images does not always help, as displaying of those elements can not always be guaranteed in a heterogeneous hospital environment. Setting a (distinctive) voxel value to one or more voxels in the pseudo CT image in order to indicate that the image is a pseudo CT image may help to reduce the risk of confusion by the user and therefore reduce the likelihood of errors.

The pseudo CT indication could for example be created by choosing distinctive values for one or more voxels in the pseudo CT image. For example symbols could be created by setting the values for multiple voxels. According to further embodiments of the invention, the voxel values are set such that readable text is formed by the set values. This could for example be used to create texts like "pseudo CT", "MRCAT", or equivalents or translations thereof. This may provide the user with a very clear indication that he is dealing with a pseudo CT image and that he therefore should be aware of potential MRI related artifacts or effects.

According to further embodiments of the invention, the setting of voxel values in order to indicate that the pseudo CT image is a pseudo CT image is done in multiple shades of grey in order to make the indication visible for a wider range of window settings. This embodiment is advantageous as different users or hospitals may choose fo different window level settings due to system specifactions or personal preferences. By means of the embodiment, visibility of the pseudo CT indication may be guaranteed over a larger range of window level settings.

According to further embodiments of the invention, the method further comprises steps of receiving a value for a table top height and determining based on the received value for the table top height, a position in the pseudo CT image of one or more voxels that indicate that the pseudo CT image is a pseudo CT image. This embodiment is advantageous, because in this way the pseudo CT indication always appears at the same location and may therefore further improve the safety of the workflow.

When a patient is scanned by means of an MRI system, he is often positioned on a table top. A representation of the table top or markers used in the table top may appear in the MRI images acquired. However, more commonly the table top cannot be seen in the MRI image. According to embodiments of the invention, a table top model is placed in the pseudo CT image and one or more voxel values in the table top model are set in order to indicate that the pseudo CT image is a pseudo CT image. Preferably, conspicuous pseudo HU values are used to clearly indicate that the image is a pseudo CT image. Placement of the table top model can either be performed by overwriting or replacing a representation of a table top in the image or just creating a table top model in the image if the table top was not visible in the original image. This embodiment is advantageous, because it allows for a clear indication that the pseudo CT image is a pseudo CT image. At the same time, adding the tabletop model fits well in the existing workflow, because also in the CT-case, a CT tabletop needs to be automatically/manually removed before the planning can be carried out. The table top model is preferably placed subtantially on the table top height, meaning that it is placed on or below the table top height, such that it always appears below the patient in the image, when the image is used for its medical purpose.

According to further embodiments of the invention, the representation of the table top is not replaced. Instead within the existing representation one or more voxel values are set in order to indicate that the pseudo CT image is a pseudo CT image.

According to a further aspect, the object is achieved by a computer program product configured for creating a pseudo CT image, based on one or more of the method steps described above. The computer program product could for example be, but is not limited to be integrated as part of an MRI system or treatment planning system. Also, it could be a stand-alone product or used as a web service. In addition or alternatively, it could be integrated in a computer program product for image processing.

These and other aspects of the invention will be apparent from and elucidated with reference to the embodiments described hereinafter.

### BRIEF DESCRIPTION OF THE EMBODIMENTS

Fig. 1 shows a bulk density pseudo CT image, continuous value pseudo CT image, and a real CT image and
Fig. 2 diagrammatically shows a method according to embodiments of the invention and
Fig. 3 diagrammatically shows a pseudo CT image created by a method according to embodiments of the invention.

### DETAILED DESCRIPTION OF THE INVENTION

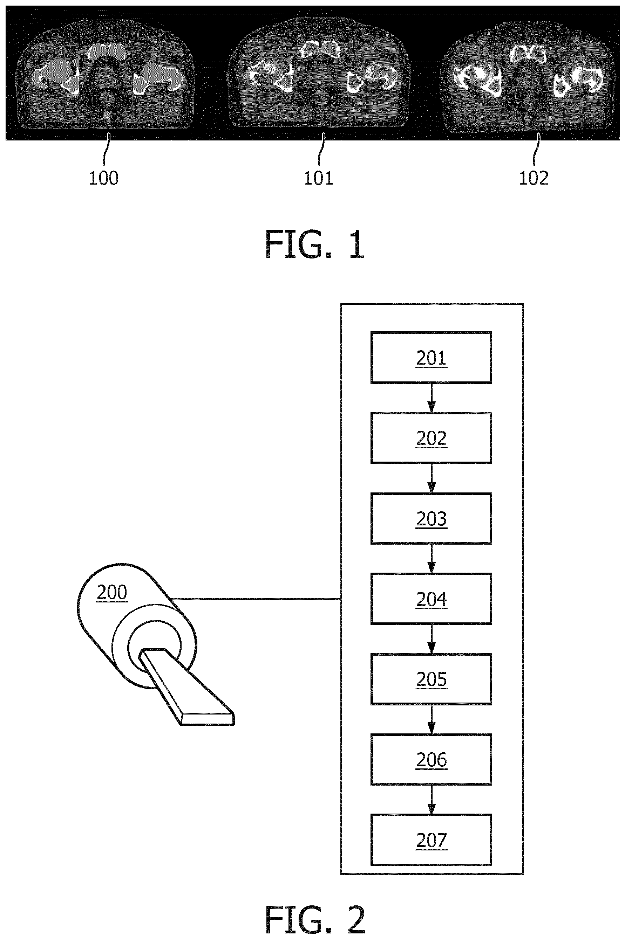

Fig. 1 shows a bulk density pseudo CT image 100, continuous value pseudo CT image 101, and a real CT image 102. It can be seen that there is similarity between the images, especially between the continuous value pseudo CT 101 image and the real CT image 102.

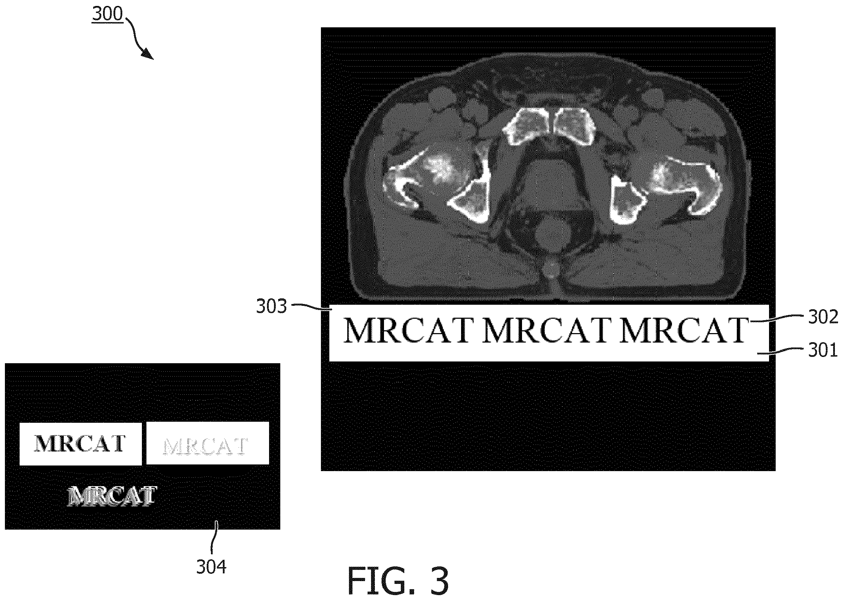

Fig. 2 diagrammatically shows a method according to embodiments of the invention. The method comprises the following steps:
- receiving one or more magnetic resonance images comprising the region of interest 201. The one or more magnetic resonance images could be any images suitable for pseudo CT creation. They could for example be DIXON images, UTE images, or separate T1 and T2 weighted image series and;
- creating a pseudo CT image by determining a pseudo Hounsfield Unit value for one or more voxels in the region of interest based on the one or more magnetic resonance images 202. Methods to create a pseudo CT image are known in the art. Such methods could for example be based on the voxel signal value in one or more of the MRI images. Also, creation of pseudo CT images could be based on segmentation of different tissue types in the one or more magnetic resonance images, or deep learning algorithms that classify or convert the voxels to HU values based on input voxel values. Also, creation of pseudo CT images could be a combination of these methods and;
- setting a voxel value to one or more voxels in the pseudo CT image in order to indicate that the image is a pseudo CT image 203. Preferably, a voxel value is chosen that is distinctive from the background values it is surrounded with in order to enhance conspicuity.
- receiving a value for a table top height 204. The tabletop height on the MRI is fixed/calibrated at a predetermined height, or deduced from MRI-visible tabletop marker positions. The tabletop height value can be used to automatically set voxel values at the correct height during reconstruction of the pseudo CT image. and
- replacing the representation of the table top by a table top model 205. Tabletop model can be a 3D HU-voxel model, or a surface model that is converted, at run-time, to voxels based on surface coordinates and HU-values attached to the surface that apply to the contained voxels.
- determining based on the received value for the table top height, a position in the pseudo CT image of one or more voxels that indicate that the pseudo CT image is a pseudo CT image 206.
- setting one or more voxel values in the table top model in order to indicate that the pseudo CT image is a pseudo CT image 207. Preferably this is done by creating texts like "pseudo CT", "MRCAT", or equivalents or translations thereof (Fig. 3, 302). Even more preferably, the setting of voxel values in order to indicate that the pseudo CT image is a pseudo CT image is done in multiple shades of grey in order to make the indication visible for a wider range of window settings (Fig. 3, 304).

The method could be implemented in a computer program product configured for creating a pseudo CT image, wherein the computer program product comprises program code means for causing a computer to carry out the steps of the method. In turn this computer program product could be integrated in an magnetic resonance imaging system 200.

Fig. 3 diagrammatically shows a pseudo CT image created by a method according to embodiments of the invention. Fig. 3 shows a continuous value pseudo CT image 300. The representation of the table top is replaced by a table top model 301. In the table top model voxel values are set such that the text "MRCAT" is formed in a distinctive voxel (grey) value 302. Preferably multiple shades of grey are used. Examples are shown in 304. As mentioned earlier "MRCAT" is just one example of the symbols or texts that could be chosen in order to indicate that the image is a pseudo CT image. The model and its text are positioned relative to the table top height 303, so that it matches the positioning of the tabletop on a radiotherapy system (e.g. LINAC) used for treatment. The table top height is not the height of the table top, but is related to the position of the table top relative to the floor in the floor in the MRI examination room. The table top height could for example be given as an off set from the imaging isocenter. However, any alternative that indicates the position of the table top in the image is possible. Preferably, the chosen table top model is similar to the table top used during the actual radiotherapy delivery.

Whilst the invention has been illustrated and described in detail in the drawings and foregoing description, such illustrations and description are to be considered illustrative or exemplary and not restrictive; the invention is not limited to the disclosed embodiments.

## Claims

1. A method for creating a pseudo CT image from a region of interest, wherein the method comprises the following steps:
- receiving one or more magnetic resonance images comprising the region of interest and;
- creating a pseudo CT image by determining a pseudo Hounsfield Unit value for one or more voxels in the region of interest based on the one or more magnetic resonance images
- setting a voxel value to one or more voxels in the pseudo CT image in order to indicate that the image is a pseudo CT image.

2. A method for creating a pseudo CT image according to claim 1, wherein the voxel values are set such that readable text is formed by the set values.

3. A method for creating a pseudo CT image according to any of claims 1-2, wherein the setting of voxel values in order to indicate that the pseudo CT image is a pseudo CT image is done in multiple shades of grey in order to make the indication visible for a wider range of window settings.

4. A method for creating a pseudo CT image according to any of claims 1-3, wherein the one or more magnetic resonance images where acquired while the region of interest was positioned on a table top, wherein the table top was positioned on a table top height, wherein the method comprises the steps of
- receiving a value indicating the table top height and;
- determining based on the received value for the table top height, a position in the pseudo CT image of one or more voxels that indicate that the pseudo CT image is a pseudo CT image.

5. A method for creating a pseudo CT image according to claim 4, wherein the value indicating the table top height is received based on a detection of markers and / or a detection of the table top in the one or more magnetic resonance images.

6. A method for creating a pseudo CT image according to any of claims 1-5, wherein the method further comprises the steps of
- creating a table top model in the pseudo CT image substantially on the table top height and;
- setting one or more voxel values in the table top model in order to indicate that the pseudo CT image is a pseudo CT image.

7. Computer program product configured for creating a pseudo CT image, wherein the computer program product comprises program code means for causing a computer to carry out the steps of a method of according to any of claims 1-6.

8. A magnetic resonance imaging system comprising a computer program product according to claim 7.

9. A treatment planning system configured for creating a radiotherapy plan comprising a computer program product according to claim 8.
